(19) **Europäisches Patentamt / European Patent Office / Office européen des brevets**

(11) **EP 4 592 692 A1**

(12) **EUROPEAN PATENT APPLICATION**
published in accordance with Art. 153(4) EPC

(43) Date of publication:
**30.07.2025 Bulletin 2025/31**

(21) Application number: **24769763.4**

(22) Date of filing: **01.03.2024**

(51) International Patent Classification (IPC):
**G01R 31/08** (2020.01)

(52) Cooperative Patent Classification (CPC):
**G01R 31/08**

(86) International application number:
**PCT/CN2024/079541**

(87) International publication number:
**WO 2024/188069 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 CN 202310234087**

(71) Applicants:
- **NR Engineering Co., Ltd.**
  **Nanjing, Jiangsu 211102 (CN)**
- **NR Electric Co., Ltd**
  **Nanjing, Jiangsu 211102 (CN)**

(72) Inventors:
- **HUANG, Tao**
  **Nanjing, Jiangsu 211102 (CN)**
- **XU, Xiaochun**
  **Nanjing, Jiangsu 211102 (CN)**
- **ZHAO, Qingchun**
  **Nanjing, Jiangsu 211102 (CN)**
- **XIE, Hua**
  **Nanjing, Jiangsu 211102 (CN)**
- **LI, Ben**
  **Nanjing, Jiangsu 211102 (CN)**
- **NIU, Huamin**
  **Nanjing, Jiangsu 211102 (CN)**
- **ZHANG, Hongxi**
  **Nanjing, Jiangsu 211102 (CN)**
- **LU, Jinfeng**
  **Nanjing, Jiangsu 211102 (CN)**
- **BU, Lizhi**
  **Nanjing, Jiangsu 211102 (CN)**
- **XU, Haiyang**
  **Nanjing, Jiangsu 211102 (CN)**

(74) Representative: **Grünecker Patent- und Rechtsanwälte**
**PartG mbB**
**Leopoldstraße 4**
**80802 München (DE)**

(54) **DISTRIBUTED TRAVELING WAVE FAULT LOCATION METHOD AND SYSTEM, AND ELECTRONIC DEVICE AND STORAGE MEDIUM**

(57)     Provided are a distributed type traveling wave fault location method and system, an electronic device, and a storage medium. The method includes: numbering traveling wave acquisition apparatuses dispersedly mounted on a line, and forming an adjacency information matrix according to mounting positions of the traveling wave acquisition apparatuses and a length parameter of the line (S100); receiving a fault traveling wave current waveform of each traveling wave acquisition apparatus, extracting traveling wave head time instant according to the fault traveling wave current waveform, and selecting a traveling wave acquisiiton apparatus of which a traveling wave head first arrives as a reference traveling wave acquisition apparatus (S200); correcting the adjacency information matrix based on data of the traveling wave head time instant (S300); acquiring all adjacent traveling wave acquisition apparatuses of the reference traveling wave acquisition apparatus according to a corrected adjacency information matrix, and dividing the adjacent traveling wave acquisition apparatuses into an upstream adjacency group and a downstream adjacency group (S400); carrying out traveling wave fault location on the upstream adjacency group and the downstream adjacency group separately, and obtaining two fault location results (S500); and determining, according to the fault location results of the upstream adjacency group and the downstream adjacency group, an adjacency group in which a fault is positioned, and determining a final fault location result (S600).

Number traveling wave acquisition apparatuses dispersedly mounted on a line, and form an adjacency information matrix according to mounting positions of the traveling wave acquisition apparatuses and a length parameter of the line — S100

Receive a fault traveling wave current waveform of each traveling wave acquisition apparatus, extract traveling wave head time according to the fault traveling wave current waveform, and select a traveling wave acquisition apparatus of which a traveling wave head first arrives as a reference traveling wave acquisition apparatus — S200

Correct the adjacency information matrix based on data of the traveling wave head time — S300

Acquire all adjacent traveling wave acquisition apparatuses of the reference traveling wave acquisition apparatus according to a corrected adjacency information matrix, and divide the adjacent traveling wave acquisition apparatuses into an upstream adjacency group and a downstream adjacency group — S400

Carry out traveling wave fault location on the upstream adjacency group and the downstream adjacency group separately, and obtain two fault location results — S500

Determine, according to the fault location results of the upstream adjacency group and the downstream adjacency group, an adjacency group in which a fault is located, and determine a final fault location result — S600

FIG. 1

# EP 4 592 692 A1

## Description

## CROSS-REFERENCE TO RELATED APPLICATIONS

The disclosure claims the benefit of priority to Chinese Patent Application No. 202310234087.8, filed with the China Patent Office on March 13, 2023 and entitled "DISTRIBUTED TYPE TRAVELING WAVE FAULT LOCATION METHOD AND SYSTEM, ELECTRONIC DEVICE, AND STORAGE MEDIUM", which is incorporated in its entirety herein by reference.

## TECHNICAL FIELD

The disclosure relates to the field of fault location of power systems, and particularly relates to a distributed type traveling wave fault location method and system, an electronic device, and a storage medium.

## BACKGROUND

Fault location is a significant means for fault patrol efficiency improvement, rapid troubleshooting, and power restoration of a power transmission and distribution line of a power system. Traveling wave fault location is used to locate, when a fault occurs, the fault according to a propagation rule of a transient traveling wave generated on a line. The traveling wave fault location is extensively applied in recent years on account of high locating accuracy. The traveling wave fault location method includes a centralized type and a distributed type. The centralized type fault location method is applicable to a line having a short length and a simple structure, while the distributed type fault location method is applicable to a complex topological line having a long length or plenty of branches. The distributed type traveling wave fault location generally includes three parts, that is, acquisition terminals, a wireless communication network, and a fault location primary station, which are dispersedly mounted on a line. Each acquisition terminal acquires a traveling wave or a power frequency signal of a mounting point on site, and transmits the traveling wave or the power frequency signal to the fault location primary station by the wireless communication network. The fault location primary station completes fault location computation according to a parameter of the line topology and information of each acquisition terminal.

The distributed type traveling wave fault location is mostly applied to a power transmission line currently. Power frequency area selection and traveling wave fault location are generally combined. That is, a fault is first located between two acquisition terminals by using power frequency signals of acquisition terminals. Then, fault location is completed by using traveling wave signals of the two acquisition terminals. However, due to poor flexibility, this method is difficult to apply to a scenario of a complex multi-branch topological line. A proper mounting position of an acquisition terminal is required to be set according to a feature of a line topology, and a specific fault location solution is required to be formulated. Hence, an application scenario of the distributed type traveling wave fault location is drastically limited. In addition, since numerous acquisition terminals are arranged, if communication of an acquisition terminal is abnormal or information is invalid, topological information will change. Thus, an original fault location solution may be ineffective, and fault location may fail.

## SUMMARY

Various exemplary embodiments of the disclosure provide a distributed type traveling wave fault location method and system, an electronic device, and a storage medium.

An objective of the disclosure is to provide a distributed type traveling wave fault location method and system, an electronic device, and a storage medium.

To realize the above objective, a solution of the disclosure is as follows:

According to a first aspect of the disclosure, a distributed type traveling wave fault location method is provided. The method includes:

step 1: numbering traveling wave acquisition apparatuses dispersedly mounted on a line, and forming, according to mounting positions of the traveling wave acquisition apparatuses and a length parameter of the line, an adjacency information matrix;

step 2: receiving a fault traveling wave current waveform of each traveling wave acquisition apparatus, extracting, according to the fault traveling wave current waveform, a traveling wave head time instant, and selecting a traveling wave acquisition apparatus of which a traveling wave head first arrives as a reference traveling wave acquisition apparatus;

step 3: correcting, according to data of the traveling wave head time instant, the adjacency information matrix;

step 4: acquiring, according to a corrected adjacency information matrix, all adjacent traveling wave acquisition apparatuses of the reference traveling wave acquisition apparatus, and dividing the adjacent traveling wave acquisition apparatuses into an upstream adjacency group and a downstream adjacency group;

step 5: separately executing a traveling wave fault location on the upstream adjacency group and the downstream adjacency group , and obtaining two fault location results; and

step 6: determining, according to the fault location results of the upstream adjacency group and the downstream adjacency group, an adjacency group in which a fault is positioned, and determining a final fault location result.

In an embodiment, the adjacency information matrix in step 1 is an N×N-dimensional matrix. Content of the matrix is as follows:

$$
\begin{bmatrix}
(\eta_{11}, L_{11}) & (\eta_{12}, L_{12}) & \cdots & (\eta_{1N}, L_{1N}) \\
(\eta_{21}, L_{21}) & (\eta_{22}, L_{22}) & \cdots & (\eta_{2N}, L_{2N}) \\
\vdots & \vdots & \vdots & \vdots \\
(\eta_{N1}, L_{N1}) & (\eta_{N2}, L_{N2}) & \cdots & (\eta_{NN}, L_{NN})
\end{bmatrix},
$$

where N denotes a total quantity of the traveling wave acquisition apparatuses; i=1,2,...,N; j=1,2,...,N;

$\eta_{ij}$ denotes a position relationship between a mounting point of traveling wave acquisition apparatus i and a mounting point of traveling wave acquisition apparatus j;

$$
\eta_{ij} = \begin{cases} 1 & i=j \text{ or traveling wave acquisition apparatus } i \text{ and traveling wave acquisition apparatus } j \text{ are adjacent to each other} \\ 0 & \text{traveling wave acquisition apparatus } i \text{ and traveling wave acquisition apparatus } j \text{ are not adjacent to each other} \end{cases};
$$

$L_{ij}$ denotes a length of a line between the mounting point of traveling wave acquisition apparatus i and the mounting point of traveling wave acquisition apparatus j; and

in a case of i=j, $L_{ij} = L_{ii}$ denotes a length from the mounting point of traveling wave acquisition apparatus i to a tail terminal of the line, and in a case that traveling wave acquisition apparatus i is mounted at the tail terminal of the line, $L_{ii}=0$.

In an embodiment, the traveling wave head time instant in step 2 includes traveling wave initial wave head time instant and fault point reflected wave head time instant.

In an embodiment, in step 3, detection is executed one by one based on data in a row corresponding to the number of the reference traveling wave acquisition apparatus in the adjacency information matrix and the data of the traveling wave head time instant. The adjacency information matrix is corrected in a case that an adjacent traveling wave acquisition apparatus of which the traveling wave head time instant is invalid is detected.

In an embodiment, a method for determining whether the traveling wave head time instant in step 3 is valid is as follows: determining, in a case where a traveling wave current waveform is successfully received by the traveling wave acquisition apparatus and the traveling wave head time instant is successfully extracted, that the traveling wave head time instant is valid, otherwise, determining that the traveling wave head time instant is invalid.

In an embodiment, in step 3, a step that the adjacency information matrix is corrected in a case that an adjacent traveling wave acquisition apparatus of which traveling wave head time instant is invalid is detected includes:

assuming that the reference traveling wave acquisition apparatus has a number of m, and a traveling wave acquisition apparatus having a number of n is adjacent to reference traveling wave acquisition apparatus m and has invalid traveling wave head time instant ;

firstly correcting all elements ($\eta_{mj}$, $L_{mj}$), (j=1~N) in an mth row of the adjacency information matrix as follows: $\eta_{mj} = \overline{\eta_{mj}} \bullet \eta_{nj} + \eta_{mj}$, where $\overline{\eta_{mj}}$ denotes negation on $\eta_{mj}$, in a case that $\eta_{mj}$ is corrected from 0 to 1, $L_{mj}$ is required to be corrected to $L_{mj} = L_{mn} + L_{nj}$, otherwise, $L_{mj}$ does not change; and

then setting $\eta_{mn}$ and $L_{mn}$ as 0.

In an embodiment, in step 4, the reference traveling wave acquisition apparatus and all the adjacent traveling wave acquisition apparatuses of the reference traveling wave acquisition apparatus are divided into the upstream adjacency group and the downstream adjacency group by taking the reference traveling wave acquisition apparatus as a boundary.

The upstream adjacency group and the downstream adjacency group both include the reference traveling wave acquisition apparatus. Every two traveling wave acquisition apparatuses in the upstream adjacency group are adjacent. Every two traveling wave acquisition apparatuses in the downstream adjacency group are adjacent. But the traveling wave acquisition apparatuses in the upstream adjacency group are not adjacent to the traveling wave acquisition apparatuses in the downstream adjacency group except the reference traveling wave acquisition apparatus.

In an embodiment, step 4 further includes: dividing, according to a power flow direction, adjacent traveling wave acquisition apparatuses in areas on two sides of the reference traveling wave acquisition apparatus into the upstream adjacency group and the downstream adjacency group.

In an embodiment, in step 5, double-terminal traveling wave fault location or single-terminal traveling wave fault location is executed on the upstream adjacency group and the downstream adjacency group separately according to a quantity of traveling wave acquisition apparatuses in an adjacency group.

In an embodiment, in step 5, a step that double-terminal traveling wave fault location or single-terminal traveling wave fault location is executed on the upstream adjacency group and the downstream adjacency group separately according to a quantity of traveling wave acquisition apparatuses in an adjacency group includes:

taking, in a case that the quantity of the traveling wave acquisition apparatuses in the adjacency group is 1, the reference traveling wave acquisition apparatus as a fault location reference terminal, and executing the single-terminal traveling wave fault location;

taking, in a case that the quantity of the traveling wave acquisition apparatuses in the adjacency group is 2, the reference traveling wave acquisition apparatus as a fault location reference terminal, and executing the double-terminal traveling wave fault location; or

executing, in a case that the quantity of the traveling wave acquisition apparatuses in the adjacency group is greater than 2, the double-terminal traveling wave fault location on each traveling wave acquisition apparatus in the adjacency group and other traveling wave acquisition apparatuses one by one, selecting a traveling wave acquisition apparatus having a greatest quantity of similar fault location results as a fault location reference terminal, and taking an average of all similar fault location results as the fault location result.

In an embodiment, a computation formula for the single-terminal traveling wave fault location in step 5 is as follows:

$$d_1 = \begin{cases} \dfrac{t_{m\_w2} - t_{m\_w1}}{2} v & L_{mm} \neq 0 \\ 0 & L_{mm} = 0 \end{cases},$$

where $d_1$ denotes a single-terminal traveling wave fault location result; m is a number of the reference traveling wave acquisition apparatus; $L_{mm}$ denotes a length from a mounting point of the reference traveling wave acquisition apparatus to a tail terminal of a line; $t_{m\_w1}$ denotes traveling wave initial wave head time instant; $t_{m\_w2}$ denotes fault point reflected wave head time instant; and $v$ denotes a traveling wave velocity.

A computation formula for the double-terminal traveling wave fault location is as follows:

$$d_2 = \frac{1}{2}\left[L_{ij} + (t_{i\_w1} - t_{j\_w1})v\right],$$

where $d_2$ denotes a double-terminal traveling wave fault location result; $L_{ij}$ denotes a length of a line between a mounting point of traveling wave acquisition apparatus i and a mounting point of traveling wave acquisition apparatus j; $t_{i\_w1}$ denotes traveling wave initial wave head time instant of traveling wave acquisition apparatus i; and $t_{j\_w1}$ denotes a traveling wave initial wave head time instant of traveling wave acquisition apparatus j.

A method for determining whether a fault location result is similar is as follows:

$$|\Delta d| < \Delta D_{set},$$

where $\Delta d$ denotes a difference between any two double-terminal traveling wave fault location results; and $\Delta D_{set}$ denotes a preset threshold, and in a case that the above formula is satisfied, it is determined that the fault location result is similar.

In an embodiment, specific steps of step 6 are as follows:

separately determining, according to the fault location results of the upstream adjacency group and the downstream adjacency group, a fault position in the adjacency group separately; deeming, in a case that the fault location result is not less than preset threshold $D_{set}$ or a fault location reference terminal is not the reference traveling wave acquisition apparatus, that a fault is located in an adjacency group area; or deeming, in a case that the fault location result is less than preset threshold $D_{set}$ and a fault location reference terminal is the reference traveling wave acquisition apparatus, that a fault is located at an adjacency group area boundary or outside an adjacency group area;

selecting, in a case that one of the upstream adjacency group and the downstream adjacency group determines that a fault is located in an adjacency group area, and the other one determines that a fault is located at an adjacency group area boundary or outside an adjacency group area, a fault location result of an adjacency group that determines that a fault is located in an adjacency group area as the final fault location result;

selecting, in a case that the upstream adjacency group and the downstream adjacency group both determine that a fault is located at an adjacency group area boundary or outside an adjacency group area, an average of the fault location results of the upstream adjacency group and the downstream adjacency group as the final fault location result; and

deeming, in a case that the upstream adjacency group and the downstream adjacency group both determine that a fault is located in an adjacency group area, that current fault location is invalid.

According to a second aspect of the disclosure, a distributed type traveling wave fault location system is provided. The system includes a topology forming module, an information receiving and processing module, a topology correcting module, an area decomposing module, a fault location computing module, and a result determining module.

The topology forming module is used for numbering traveling wave acquisition apparatuses dispersedly mounted on a line, and forming an adjacency information matrix according to mounting positions of the traveling wave acquisition apparatuses and a length parameter of the line.

The information receiving and processing module is configured to receive a fault traveling wave current waveform of each traveling wave acquisition apparatus, extract traveling wave head time instant according to the fault traveling wave current waveform, and select a traveling wave acquisition apparatus of which traveling wave head first arrives as a reference traveling wave acquisition apparatus.

The topology correcting module is configured to correct the adjacency information matrix based on data of the traveling wave head time instant.

The area decomposing module is configured to acquire all adjacent traveling wave acquisition apparatuses of the reference traveling wave acquisition apparatus according to a corrected adjacency information matrix, and divide the adjacent traveling wave acquisition apparatuses into an upstream adjacency group and a downstream adjacency group.

The fault location computing module is configured to carry out traveling wave fault location on the upstream adjacency group and the downstream adjacency group separately, and obtain two fault location results.

The result determining module is configured to determine, according to the fault location results of the upstream adjacency group and the downstream adjacency group, an adjacency group in which a fault is positioned, and determine a final fault location result.

According to a third aspect of the disclosure, an electronic device is provided. The electronic device includes: a processor; and

a memory, where the memory stores a computer instruction, and when executed by the processor, the computer instruction causes the processor to carry out the method described in the first aspect.

According to a fourth aspect of the disclosure, a non-transitory computer storage medium is provided. The non-transitory computer storage medium stores a computer program. When executed by a plurality of processors, the computer program causes the processors to carry out the method described in the first aspect.

Beneficial effects of the disclosure are as follows: At least problems of poor adaptability of conventional distributed type traveling wave fault location to a complex line topology and poor reliability in the absence of information can be solved. Specifically, in a fault location process, power frequency information is not required, and no special requirement is imposed on a mounting position of a traveling wave acquisition apparatus. The disclosure can be used for fault location of a conventional branch-free single line without reliance on a power frequency component, and thus can adapt to various line topologies. Moreover, the disclosure is suitable for fault location of a complex multi-branch topological line. In addition, abnormal communication or invalid information of the traveling wave acquisition apparatus is considered, no special requirement is imposed on the mounting positioned of the traveling wave acquisition apparatus, and an information fault-tolerant capability is high. Thus, flexibility and reliability of distributed type traveling wave fault location are improved.

## BRIEF DESCRIPTION OF THE DRAWINGS

FIG. 1 is a flowchart of a distributed type traveling wave fault location method according to an embodiment of the disclosure;

FIG. 2 is a schematic diagram of a line topology according to an embodiment of the disclosure;

FIG. 3 is a flowchart of correcting an adjacency information matrix according to an embodiment of the disclosure;

FIG. 4 is a schematic diagram of a fault of a line topology according to an embodiment of the disclosure;

FIG. 5 is a schematic diagram of adjacency group division according to an embodiment of the disclosure;

FIG. 6 is a schematic diagram of a distributed type traveling wave fault location system according to an embodiment of the disclosure; and

FIG. 7 is a structural diagram of an electronic device according to an embodiment of the disclosure.

## DETAILED DESCRIPTION

The technical solutions of the disclosure will be further described in detail below in combination with the accompanying drawings and particular embodiments such that a person skilled in the art can better understand and implement the disclosure. However, the embodiments are not intended to limit the disclosure.

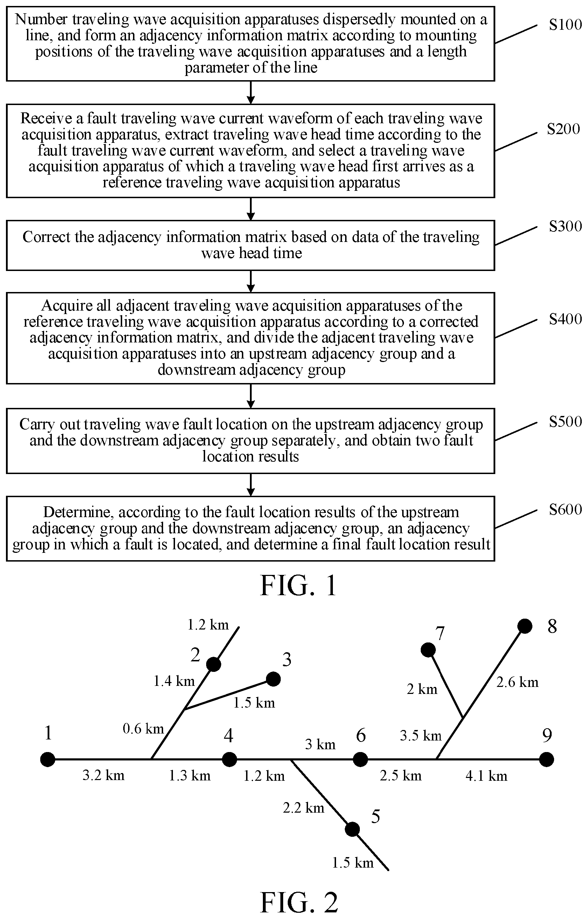

FIG. 1 is a flowchart of a distributed type traveling wave fault location method according to an embodiment of the disclosure. As shown in FIG. 1, the method includes steps as follows:

In S100, traveling wave acquisition apparatuses dispersedly mounted on a line are numbered. An adjacency information matrix is formed according to mounting positions of the traveling wave acquisition apparatuses and a length parameter of the line.

In an embodiment, in S100, an N×N-dimensional adjacency information matrix is formed according to the mounting positions of the traveling wave acquisition apparatuses and the length parameter of the line. Content of the matrix is as follows:

$$\begin{bmatrix} (\eta_{11},L_{11}) & (\eta_{12},L_{12}) & \cdots & (\eta_{1N},L_{1N}) \\ (\eta_{21},L_{21}) & (\eta_{22},L_{22}) & \cdots & (\eta_{2N},L_{2N}) \\ \vdots & \vdots & \vdots & \vdots \\ (\eta_{N1},L_{N1}) & (\eta_{N2},L_{N2}) & \cdots & (\eta_{NN},L_{NN}) \end{bmatrix},$$

where N denotes a total quantity of the traveling wave acquisition apparatuses; i=1,2,...,N; j=1,2,...,N;

$\eta_{ij}$ denotes a position relationship between a mounting point of traveling wave acquisition apparatus i and a mounting point of traveling wave acquisition apparatus j;

$$\eta_{ij} = \begin{cases} 1 & i=j \text{ or traveling wave acquisition apparatus } i \text{ and traveling wave acquisition apparatus } j \text{ are adjacent to each other} \\ 0 & \text{traveling wave acquisition apparatus } i \text{ and traveling wave acquisition apparatus } j \text{ are not adjacent to each other} \end{cases};$$

$L_{ij}$ denotes a length of a line between the mounting point of traveling wave acquisition apparatus i and the mounting point of traveling wave acquisition apparatus j; and in a case of i=j, $L_{ij}=L_{ii}$ denotes a length from the mounting point of traveling wave acquisition apparatus i to a tail terminal of the line, and in a case that traveling wave acquisition apparatus i is mounted at the tail terminal of the line, $L_{ii}=0$.

With a line topology in FIG. 2 as an example, a total of 9 traveling wave acquisition apparatuses are mounted in the figure and numbered 1 to 9. According to mounting positions of the traveling wave acquisition apparatuses and a length of each line, the following adjacency information matrix may be formed according to the above rule.

$$\begin{bmatrix} (1,0) & (1,5.2) & (1,5.3) & (1,4.5) & (0,0) & (0,0) & (0,0) & (0,0) & (0,0) \\ (1,5.2) & (1,1.2) & (1,2.9) & (1,3.3) & (0,0) & (0,0) & (0,0) & (0,0) & (0,0) \\ (1,5.3) & (1,2.9) & (1,0) & (1,3.4) & (0,0) & (0,0) & (0,0) & (0,0) & (0,0) \\ (1,4.5) & (1,3.3) & (1,3.4) & (1,0) & (1,3.4) & (1,4.2) & (0,0) & (0,0) & (0,0) \\ (0,0) & (0,0) & (0,0) & (1,3.4) & (1,1.5) & (1,5.2) & (0,0) & (0,0) & (0,0) \\ (0,0) & (0,0) & (0,0) & (1,4.2) & (1,5.2) & (1,0) & (1,8) & (1,8.6) & (1,6.6) \\ (0,0) & (0,0) & (0,0) & (0,0) & (0,0) & (1,8) & (1,0) & (1,6.6) & (1,9.6) \\ (0,0) & (0,0) & (0,0) & (0,0) & (0,0) & (1,8.6) & (1,6.6) & (1,0) & (1,10.2) \\ (0,0) & (0,0) & (0,0) & (0,0) & (0,0) & (1,6.6) & (1,9.6) & (1,10.2) & (1,0) \end{bmatrix}$$

In S200, a fault traveling wave current waveform of each traveling wave acquisition apparatus is received. Traveling wave head time instant is extracted according to the fault traveling wave current waveform. A traveling wave acquisition apparatus of which a traveling wave head first arrives is selected as a reference traveling wave acquisition apparatus.

In an embodiment, the traveling wave head time instant includes traveling wave initial wave head time instant and fault point reflected wave head time instant.

In S300, the adjacency information matrix is corrected based on data of the traveling wave head time instant.

In an embodiment, in S300, detection is executed one by one based on data in a row corresponding to the number of the reference traveling wave acquisition apparatus in the adjacency information matrix and the data of the traveling wave head time instant. The adjacency information matrix is corrected in a case that an adjacent traveling wave acquisition apparatus of which traveling wave head time instant is invalid is detected.

A method for determining whether the traveling wave head time instant is valid is as follows: When a traveling wave current waveform is successfully received by the traveling wave acquisition apparatus and the traveling wave head time instant is successfully extracted, it is determined that the traveling wave head time instant is valid. Otherwise, it is determined that the traveling wave head time instant is invalid.

The step that the adjacency information matrix is corrected in a case that an adjacent traveling wave acquisition apparatus of which traveling wave head time instant is invalid is detected includes:

It is assumed that the reference traveling wave acquisition apparatus has a number of m, and a traveling wave acquisition apparatus having a number of n is adjacent to reference traveling wave acquisition apparatus m and has invalid traveling wave head time instant.

Firstly, all elements ($\eta_{mj}$, $L_{mj}$), (j=1~N) in an mth row of the adjacency information matrix are corrected as follows: $\eta_{mj}=\overline{\eta_{mj}}\bullet\eta_{nj}+\eta_{mj}$, where $\overline{\eta_{mj}}$ denotes negation on $\eta_{mj}$, in a case that $\eta_{mj}$ is corrected from 0 to 1, $L_{mj}$ is required to be corrected to $L_{mj}=L_{mn}+L_{nj}$, otherwise, $L_{mj}$ does not change.

Then, $\eta_{mn}$ and $L_{mn}$ are set as 0.

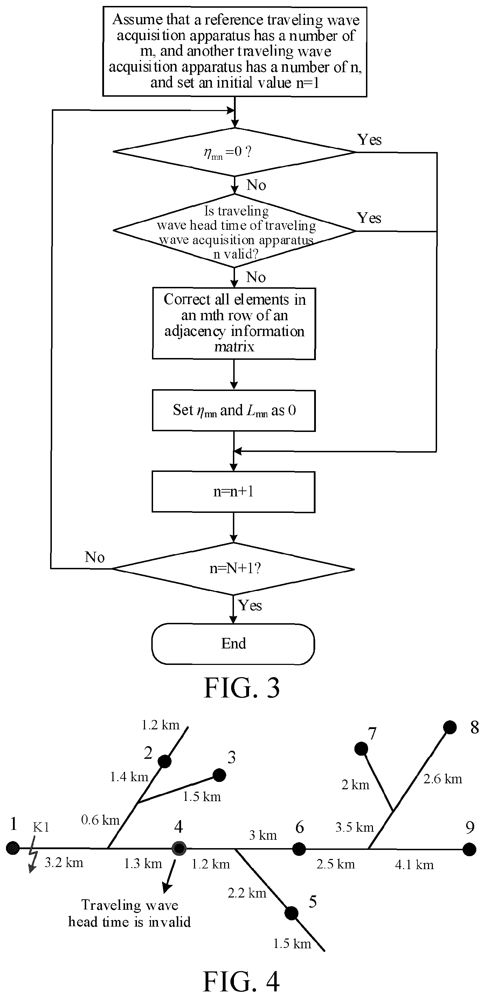

As shown in FIG. 3, a computer execution process of correcting an adjacency information matrix provided in the embodiment is shown.

a) It is assumed that a reference traveling wave acquisition apparatus has a number of m, and another traveling wave acquisition apparatus has a number of n. An initial value is set as n=1. Step b) is performed.

b) In a case that $\eta_{mn}$ is equal to 0 or $\eta_{mn}$ is equal to 1, and traveling wave head time instant of an nth traveling wave acquisition apparatus is valid, step d) is performed, otherwise, step c) is executed.

c) Firstly, all elements ($\eta_{mj}$, $L_{mj}$), (j=1~N) in an mth row of the adjacency information matrix are corrected as follows: $\eta_{mj}=\overline{\eta_{mj}}\bullet\eta_{nj}+\eta_{mj}$, where $\overline{\eta_{mj}}$ denotes negation on $\eta_{mj}$, in a case that $\eta_{mj}$ is corrected from 0 to 1, $L_{mj}$ is required to be corrected to $L_{mj}=L_{mn}+L_{nj}$, otherwise, $L_{mj}$ does not change. Then, $\eta_{mn}$ and $L_{mn}$ are set as 0. Step d) is performed.

d) n=n+1, and in a case that n=N+1, the correction process ends, otherwise, step b) is returned.

In another embodiment, a determining condition in step b) may be modified. Specific content after modification is as follows:

b) In a case that $\eta_{mn}$ is equal to 1 and traveling wave head time instant of traveling wave acquisition apparatus n is invalid, step c) is executed, otherwise, step d) is performed.

To understand selection of the reference traveling wave acquisition apparatus and a correction flow of the adjacency information matrix in detail, an example in which a point K1 is faulty and traveling wave head time instant of traveling wave acquisition apparatus 4 is invalid in FIG. 4 is taken for description. Since the point K1 is faulty, traveling wave acquisition apparatus 1 closest to the fault point first detects traveling wave head time instant. Thus, traveling wave acquisition apparatus 1 is the reference traveling wave acquisition apparatus, m=1, and an initial value is n=1. Because $\eta_{11}$=1 and traveling wave head time instant of traveling wave acquisition apparatus 1 are valid, n=2 is set for continuation. Because $\eta_{12}$=1 and traveling wave head time instant of traveling wave acquisition apparatus 2 are valid, n=3 is set for continuation. Because $\eta_{13}$=1 and traveling wave head time instant of traveling wave acquisition apparatus 3 are valid, n=4 is set for continuation. Because $\eta_{14}$=1 and traveling wave head time instant of traveling wave acquisition apparatus 4 are valid, all $\eta_{1j}$(j=1~9) in a 1st row are corrected according to a table as follows:

| j | 1 | 2 | 3 | 4 | 5 | 6 | 7 | 8 | 9 |
|---|---|---|---|---|---|---|---|---|---|
| Original $\eta_{1j}$ | 1 | 1 | 1 | 1 | 0 | 0 | 0 | 0 | 0 |
| $\eta_{4j}$ | 1 | 1 | 1 | 1 | 1 | 1 | 0 | 0 | 0 |
| $\eta_{1j}$ corrected according to formula $\eta_{1j}=\overline{\eta_{1j}}\bullet\eta_{4j}+\eta_{1j}$ | 1 | 1 | 1 | 1 | 1 | 1 | 0 | 0 | 0 |

Since $\eta_{15}$ and $\eta_{16}$ are both corrected from 0 to 1, $L_{15}$ and $L_{16}$ are required to be corrected at the same time as

follows: $L_{15}=L_{14}+L_{45}=7.9$km and $L_{16}=L_{14}+L_{46}=8.7$km. Then, $\eta_{14}$ and $L_{14}$ are set as 0, an adjacency information matrix currently corrected is as follows:

$$
\begin{bmatrix}
(1,0) & (1,5.2) & (1,5.3) & (0,0) & (1,7.9) & (1,8.7) & (0,0) & (0,0) & (0,0) \\
(1,5.2) & (1,1.2) & (1,2.9) & (1,3.3) & (0,0) & (0,0) & (0,0) & (0,0) & (0,0) \\
(1,5.3) & (1,2.9) & (1,0) & (1,3.4) & (0,0) & (0,0) & (0,0) & (0,0) & (0,0) \\
(1,4.5) & (1,3.3) & (1,3.4) & (1,0) & (1,3.4) & (1,4.2) & (0,0) & (0,0) & (0,0) \\
(0,0) & (0,0) & (0,0) & (1,3.4) & (1,1.5) & (1,5.2) & (0,0) & (0,0) & (0,0) \\
(0,0) & (0,0) & (0,0) & (1,4.2) & (1,5.2) & (1,0) & (1,8) & (1,8.6) & (1,6.6) \\
(0,0) & (0,0) & (0,0) & (0,0) & (0,0) & (1,8) & (1,0) & (1,6.6) & (1,9.6) \\
(0,0) & (0,0) & (0,0) & (0,0) & (0,0) & (1,8.6) & (1,6.6) & (1,0) & (1,10.2) \\
(0,0) & (0,0) & (0,0) & (0,0) & (0,0) & (1,6.6) & (1,9.6) & (1,10.2) & (1,0)
\end{bmatrix}
$$

In a case of n=5, $\eta_{15}=1$. Moreover, traveling wave head time instant of traveling wave acquisition apparatus 5 is valid. Then, n=6 is set for continuation.

In a case of n=6, $\eta_{16}=1$. Moreover, traveling wave head time instant of traveling wave acquisition apparatus 6 is valid. Then, n=7 is set for continuation.

In a case of n=7, $\eta_{17}=0$. Then, n=8 is set for continuation. In a case of n=8, $\eta_{18}=0$. Then, n=9 is set for continuation. In a case of n=9, $\eta_{19}=0$. Then, n=10 is set. Since n=N+1=10, the correction flow ends.

A corrected adjacency information matrix is finally obtained as follows:

$$
\begin{bmatrix}
(1,0) & (1,5.2) & (1,5.3) & (0,0) & (1,7.9) & (1,8.7) & (0,0) & (0,0) & (0,0) \\
(1,5.2) & (1,1.2) & (1,2.9) & (1,3.3) & (0,0) & (0,0) & (0,0) & (0,0) & (0,0) \\
(1,5.3) & (1,2.9) & (1,0) & (1,3.4) & (0,0) & (0,0) & (0,0) & (0,0) & (0,0) \\
(1,4.5) & (1,3.3) & (1,3.4) & (1,0) & (1,3.4) & (1,4.2) & (0,0) & (0,0) & (0,0) \\
(0,0) & (0,0) & (0,0) & (1,3.4) & (1,1.5) & (1,5.2) & (0,0) & (0,0) & (0,0) \\
(0,0) & (0,0) & (0,0) & (1,4.2) & (1,5.2) & (1,0) & (1,8) & (1,8.6) & (1,6.6) \\
(0,0) & (0,0) & (0,0) & (0,0) & (0,0) & (1,8) & (1,0) & (1,6.6) & (1,9.6) \\
(0,0) & (0,0) & (0,0) & (0,0) & (0,0) & (1,8.6) & (1,6.6) & (1,0) & (1,10.2) \\
(0,0) & (0,0) & (0,0) & (0,0) & (0,0) & (1,6.6) & (1,9.6) & (1,10.2) & (1,0)
\end{bmatrix}
$$

It can be seen that after correction, adjacent traveling wave acquisition apparatuses of traveling wave acquisition apparatus 1 change from original traveling wave acquisition apparatus 1, traveling wave acquisition apparatus 2, traveling wave acquisition apparatus 3, and traveling wave acquisition apparatus 4 to traveling wave acquisition apparatus 1, traveling wave acquisition apparatus 2, traveling wave acquisition apparatus 3, traveling wave acquisition apparatus 5, and traveling wave acquisition apparatus 6.

In S400, all adjacent traveling wave acquisition apparatuses of the reference traveling wave acquisition apparatus are acquired according to a corrected adjacency information matrix. The adjacent traveling wave acquisition apparatuses are divided into an upstream adjacency group and a downstream adjacency group.

In an embodiment, in S400, the reference traveling wave acquisition apparatus and all the adjacent traveling wave acquisition apparatuses of the reference traveling wave acquisition apparatus are divided into the upstream adjacency group and the downstream adjacency group by taking the reference traveling wave acquisition apparatus as a boundary. The upstream adjacency group and the downstream adjacency group both include the reference traveling wave acquisition apparatus. Every two traveling wave acquisition apparatuses in the upstream adjacency group are adjacent. Every two traveling wave acquisition apparatuses in the downstream adjacency group are adjacent. But the traveling wave acquisition apparatuses in the upstream adjacency group are not adjacent to the traveling wave acquisition apparatuses in the downstream adjacency group except the reference traveling wave acquisition apparatus.

In an embodiment, adjacent traveling wave acquisition apparatuses in areas on two sides of the reference traveling wave acquisition apparatus into the upstream adjacency group and the downstream adjacency group may be divided according to a power flow direction.

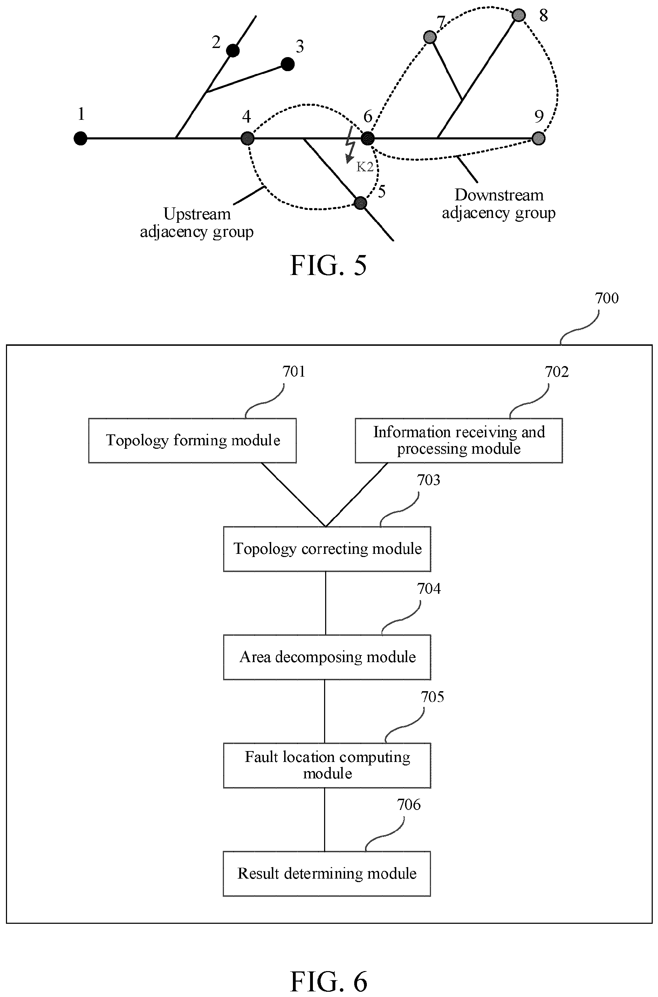

In FIG. 4 and FIG. 5, it is assumed that a power flow direction is from traveling wave acquisition apparatus 1 to another traveling wave acquisition apparatus.

In FIG. 4, the point K1 is faulty, and traveling wave acquisition apparatus 1 is the reference traveling wave acquisition apparatus. An upstream adjacency group of the reference traveling wave acquisition apparatus is {1}. A downstream adjacency group is {1, 2, 3, 5, 6}.

In FIG. 5, a point K2 is faulty, and traveling wave acquisition apparatus 6 is the reference traveling wave acquisition apparatus. An upstream adjacency group of the reference traveling wave acquisition apparatus is {4, 5, 6}. A downstream adjacency group is {6, 7, 8, 9}.

In S500, traveling wave fault location is executed on the upstream adjacency group and the downstream adjacency group separately. Two fault location results are obtained.

In an embodiment, in S500, double-terminal traveling wave fault location or single-terminal traveling wave fault location is executed on the upstream adjacency group and the downstream adjacency group separately according to a quantity of traveling wave acquisition apparatuses in an adjacency group.

A specific method is as follows:

A. In a case that the quantity of the traveling wave acquisition apparatuses in the adjacency group is 1, the reference traveling wave acquisition apparatus is taken as a fault location reference terminal, and the single-terminal traveling wave fault location is executed.

A computation formula for the single-terminal traveling wave fault location is as follows:

$$d_1 = \begin{cases} \dfrac{t_{m\_w2} - t_{m\_w1}}{2} v & L_{mm} \neq 0 \\ 0 & L_{mm} = 0 \end{cases},$$

where $d_1$ is a single-terminal traveling wave fault location result; m is a number of the reference traveling wave acquisition apparatus; $L_{mm}$ denotes a length of a distance between a mounting point of the reference traveling wave acquisition apparatus and a tail terminal of a line; $t_{m\_w1}$ is traveling wave initial wave head time instant; $t_{m\_w2}$ denotes fault point reflected wave head time instant; and $v$ is a traveling wave velocity.

B. In a case that the quantity of the traveling wave acquisition apparatuses in the adjacency group is 2, the reference traveling wave acquisition apparatus is taken as a fault location reference terminal, and the double-terminal traveling wave fault location is executed.

A computation formula for the double-terminal traveling wave fault location is as follows:

$$d_2 = \frac{1}{2}[L_{ij} + (t_{i\_w1} - t_{j\_w1})v],$$

where $d_2$ denotes a double-terminal traveling wave fault location result; $L_{ij}$ denotes a length of a line between a mounting point of traveling wave acquisition apparatus i and a mounting point of traveling wave acquisition apparatus j; $t_{i\_w1}$ denotes traveling wave initial wave head time instant of traveling wave acquisition apparatus i; and $t_{j\_w1}$ denotes traveling wave initial wave head time instant of traveling wave acquisition apparatus j; and $v$ denotes a traveling wave velocity.

C. In a case that the quantity of the traveling wave acquisition apparatuses in the adjacency group is greater than 2, the double-terminal traveling wave fault location is executed on each traveling wave acquisition apparatus in the adjacency group and other traveling wave acquisition apparatuses one by one. A traveling wave acquisition apparatus having a greatest quantity of similar fault location results is selected as a fault location reference terminal. An average of all similar fault location results is taken as the fault location result.

A method for determining whether a fault location result is similar is as follows:

$$|\Delta d| < \Delta D_{set},$$

where $\Delta d$ denotes a difference between any two double-terminal traveling wave fault location results; and $\Delta D_{set}$ denotes a preset threshold, and in a case that the above formula is satisfied, it is determined that the fault location result is similar.

In S600, according to the fault location results of the upstream adjacency group and the downstream adjacency group, an adjacency group in which a fault is positioned is determined, and a final fault location result is determined.

In an embodiment, specific steps are as follows:

a) According to the fault location results of the upstream adjacency group and the downstream adjacency group, a fault position in an adjacency group is determined separately: In a case that the fault location result is not less than preset threshold $D_{set}$ or a fault location reference terminal is not the reference traveling wave acquisition apparatus, it is deemed that a fault is located in an adjacency group area; or in a case that a fault location result is less than preset threshold $D_{set}$ and a fault location reference terminal is the reference traveling wave acquisition apparatus, it is deemed that a fault is located at an adjacency group area boundary or outside an adjacency group area.

b) In a case that one of the upstream adjacency group and the downstream adjacency group determines that a fault is located in an adjacency group area, and the other one determines that a fault is located at an adjacency group area boundary or outside an adjacency group area, a fault location result of an adjacency group that determines that a fault is located in an adjacency group area is selected as the final fault location result.

c) In a case that the upstream adjacency group and the downstream adjacency group both determine that a fault is located at an adjacency group area boundary or outside an adjacency group area, an average of the fault location results of the upstream adjacency group and the downstream adjacency group is selected as the final fault location result.

d) In a case that the upstream adjacency group and the downstream adjacency group both determine that a fault is located in an adjacency group area, it is deemed that current fault location is invalid.

As shown in FIG. 6, a distributed type traveling wave fault location system 700 includes: a topology forming module 701, an information receiving and processing module 702, a topology correcting module 703, an area decomposing module 704, a fault location computing module 705, and a result determining module 706.

The topology forming module 701 is used for numbering traveling wave acquisition apparatuses dispersedly mounted on a line, and forming an adjacency information matrix according to mounting positions of the traveling wave acquisition apparatuses and a length parameter of the line.

The information receiving and processing module 702 is used for receiving a fault traveling wave current waveform of each traveling wave acquisition apparatus, extracting traveling wave head time instant according to the fault traveling wave current waveform, and selecting a traveling wave acquisition apparatus of which a traveling wave head first arrives as a reference traveling wave acquisition apparatus.

The topology correcting module 703 is used for correcting the adjacency information matrix based on data of the traveling wave head time instant.

The area decomposing module 704 is used for acquiring all adjacent traveling wave acquisition apparatuses of the reference traveling wave acquisition apparatus according to a corrected adjacency information matrix, and dividing the adjacent wave acquisition apparatuses into an upstream adjacency group and a downstream adjacency group.

The fault location computing module 705 is used for carrying out traveling wave fault location on the upstream adjacency group and the downstream adjacency group separately, and obtaining two fault location results.

The result determining module 706 is used for determining, according to the fault location results of the upstream adjacency group and the downstream adjacency group, an adjacency group in which a fault is positioned, and determining a final fault location result.

The distributed type traveling wave fault location system 700 enables functions similar to those of the method provided above. Other functions can be obtained with reference to the above descriptions, and will not be repeated herein.

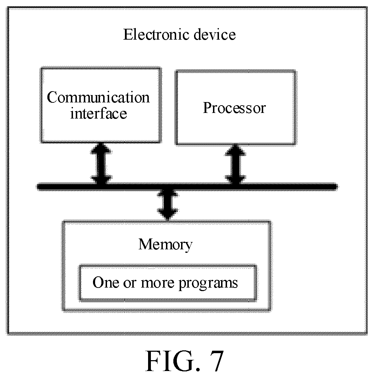

With reference to FIG. 7, an electronic device is provided in FIG. 7. The electronic device includes a processor; and a memory. The memory stores a computer instruction. When the computer instruction is executed by the processor, the processor is caused to implement the method and detailed solution shown in FIG. 1 when executing the computer instruction.

It should be understood that the above apparatus embodiments are merely exemplary, and the apparatus disclosed in the disclosure may be implemented through other methods. For example, division of the units/modules in the above embodiments is merely a type of logic function division. Another division method is also possible during actual implementation. For example, a plurality of units, modules, or components may be combined or integrated into another system, or some features may be omitted or not executed.

In addition, unless otherwise specified, functional units/modules in the embodiments of the disclosure may be integrated into one unit/module, or each unit/module may be physically present separately, or two or more units/modules may be integrated together. The above integrated unit/module may be implemented in a form of hardware, or may be implemented in a form of a software program module.

If the integrated unit/module is implemented in a form of hardware, the hardware may be a digital circuit, an analog circuit, etc. Physical implementation of the hardware structure includes but is not limited to a transistor, a memristor, etc. Unless otherwise specified, the processor or chip may be any suitable hardware processor, such as a center processing unit (CPU), a graphics processing unit (GPU), a field-programmable gate array (FPGA), a digital signal processor (DSP), and an application specific integrated circuit (ASIC). Unless otherwise specified, an on-chip cache, an off-chip internal storage, and a memory may be any suitable magnetic storage media or magneto-optical storage media, such as a resistive random access memory (RRAM), a dynamic random access memory (DRAM), a static random-access memory (SRAM), an enhanced dynamic random access memory (EDRAM), a high-bandwidth memory (HBM), and a hybrid memory cube (HMC).

If the integrated unit/module is implemented in a form of a software program module and sold or used as an independent product, the integrated unit/module may be stored in a computer-readable memory. Based on such understanding, a technical solution of the disclosure may be embodied in a form of a software product in essence or in part that contributes to the prior art or in part or whole. The computer software product is stored in a memory, and includes several instructions to cause one piece of computer device (which may be a personal computer, a server, a network device, etc.) to carry out all or some of steps of the method in each embodiment of the disclosure. The above memory includes: a universal serial bus flash disk, a read-only memory (ROM), a random access memory (RAM), a mobile hard disk, a magnetic disk, an optical disk, and other media capable of storing program codes.

An embodiment of the disclosure further includes a non-transitory computer storage medium. The non-transitory computer storage medium stores a computer program. The computer program causes the processors to carry out the method and detailed solution shown in FIG. 1 when executed by a plurality of processors.

The disclosure is not limited to the above embodiments. The descriptions in the above embodiments are merely used for helping understand the core idea of the disclosure. If modifications or equivalent substitutions are made to the disclosure according to the idea of the disclosure, any change made in particular implementations and application scopes should fall within the scope of protection of the disclosure.

## Claims

1. A distributed type traveling wave fault location method, comprising:

   step 1: numbering traveling wave acquisition apparatuses dispersedly mounted on a line, and forming, according to mounting positions of the traveling wave acquisition apparatuses and a length parameter of the line, an adjacency information matrix;
   step 2: receiving a fault traveling wave current waveform of each traveling wave acquisition apparatus, extracting, according to the fault traveling wave current waveform, a traveling wave head time instant, and selecting a traveling wave acquisition apparatus of which a traveling wave head first arrives as a reference traveling wave acquisition apparatus;
   step 3: correcting, according to data of the traveling wave head time instant, the adjacency information matrix;
   step 4: acquiring, according to a corrected adjacency information matrix, all adjacent traveling wave acquisition apparatuses of the reference traveling wave acquisition apparatus, and dividing the adjacent traveling wave acquisition apparatuses into an upstream adjacency group and a downstream adjacency group;
   step 5: separately executing a traveling wave fault location on the upstream adjacency group and the downstream adjacency group , and obtaining two fault location results; and
   step 6: determining, according to the fault location results of the upstream adjacency group and the downstream adjacency group, an adjacency group in which a fault is positioned, and determining a final fault location result.

2. The distributed type traveling wave fault location method according to claim 1, **characterized in that**

   the adjacency information matrix in step 1 is an N×N-dimensional matrix, and content of the matrix is as follows:

$$\begin{bmatrix} (\eta_{11},L_{11}) & (\eta_{12},L_{12}) & \cdots & (\eta_{1N},L_{1N}) \\ (\eta_{21},L_{21}) & (\eta_{22},L_{22}) & \cdots & (\eta_{2N},L_{2N}) \\ \vdots & \vdots & \vdots & \vdots \\ (\eta_{N1},L_{N1}) & (\eta_{N2},L_{N2}) & \cdots & (\eta_{NN},L_{NN}) \end{bmatrix},$$

   N denotes a total quantity of the traveling wave acquisition apparatuses; i=1,2,...,N; j=1,2,...,N;
   $\eta_{ij}$ denotes a position relationship between a mounting point of traveling wave acquisition apparatus i and a mounting point of traveling wave acquisition apparatus j;

$$\eta_{ij} = \begin{cases} 1 & i=j \text{ or traveling wave acquisition apparatus i and traveling wave acquisition apparatus j are adjacent to each other} \\ 0 & \text{traveling wave acquisition apparatus i and traveling wave acquisition apparatus j are not adjacent to each other} \end{cases};$$

$L_{ij}$ denotes a length of a line between the mounting point of traveling wave acquisition apparatus i and the mounting point of traveling wave acquisition apparatus j; and

in a case of i=j, $L_{ij}=L_{ii}$ denotes a length from the mounting point of traveling wave acquisition apparatus i to a tail terminal of the line, and in a case that traveling wave acquisition apparatus i is mounted at the tail terminal of the line, $L_{ii}=0$.

3. The distributed type traveling wave fault location method according to claim 1, **characterized in that** the traveling wave head time instant in step 2 includes a traveling wave initial wave head time instant and a fault point reflected wave head time instant.

4. The distributed type traveling wave fault location method according to claim 1, **characterized in that** in step 3, detection is executed one by one based on data in a row corresponding to the number of the reference traveling wave acquisition apparatus in the adjacency information matrix and the data of the traveling wave head time instant, and the adjacency information matrix is corrected in a case that an adjacent traveling wave acquisition apparatus of which the traveling wave head time instant is invalid is detected.

5. The distributed type traveling wave fault location method according to claim 4, **characterized in that** a method for determining whether the traveling wave head time instant in step 3 is valid is as follows: determining, in a case where a traveling wave current waveform is successfully received by the traveling wave acquisition apparatus and the traveling wave head time instant is successfully extracted, that the traveling wave head time instant is valid, otherwise, determining that the traveling wave head time instant is invalid.

6. The distributed type traveling wave fault location method according to claim 4, **characterized in that** in step 3, a step that the adjacency information matrix is corrected in a case that an adjacent traveling wave acquisition apparatus of which traveling wave head time instant is invalid is detected includes:

assuming that the reference traveling wave acquisition apparatus has a number of m, and a traveling wave acquisition apparatus having a number of n is adjacent to reference traveling wave acquisition apparatus m and has invalid traveling wave head time instant;

firstly correcting all elements $(\eta_{mj}, L_{mj})$, (j=1~N) in an mth row of the adjacency information matrix as follows: $\eta_{mj}=\overline{\eta_{mj}} \cdot \eta_{nj}+\eta_{mj}$, wherein $\overline{\eta_{mj}}$ denotes negation on $\eta_{mj}$, in a case that $\eta_{mj}$ is corrected from 0 to 1, $L_{mj}$ is required to be corrected to $L_{mj}=L_{mn}+L_{nj}$, otherwise, $L_{mj}$ does not change; and then setting $\eta_{mn}$ and $L_{mn}$ as 0.

7. The distributed type traveling wave fault location method according to claim 1, **characterized in that**

in step 4, the reference traveling wave acquisition apparatus and all the adjacent traveling wave acquisition apparatuses of the reference traveling wave acquisition apparatus are divided into the upstream adjacency group and the downstream adjacency group by taking the reference traveling wave acquisition apparatus as a boundary;

the upstream adjacency group and the downstream adjacency group both include the reference traveling wave acquisition apparatus; and every two traveling wave acquisition apparatuses in the upstream adjacency group are adjacent, every two traveling wave acquisition apparatuses in the downstream adjacency group are adjacent, but the traveling wave acquisition apparatuses in the upstream adjacency group are not adjacent to the traveling wave acquisition apparatuses in the downstream adjacency group except the reference traveling wave acquisition apparatus.

8. The distributed type traveling wave fault location method according to claim 7, **characterized in that** step 4 further includes: dividing, according to a power flow direction, adjacent traveling wave acquisition apparatuses in areas on two sides of the reference traveling wave acquisition apparatus into the upstream adjacency group and the downstream adjacency group.

9. The distributed type traveling wave fault location method according to claim 1, **characterized in that** in step 5, double-terminal traveling wave fault location or single-terminal traveling wave fault location is executed on the upstream adjacency group and the downstream adjacency group separately according to a quantity of traveling wave acquisition apparatuses in an adjacency group.

10. The distributed type traveling wave fault location method according to claim 9, **characterized in that** in step 5, a step that double-terminal traveling wave fault location or single-terminal traveling wave fault location is executed on the upstream adjacency group and the downstream adjacency group separately according to a quantity of traveling wave acquisition apparatuses in an adjacency group includes:

taking, in a case that the quantity of the traveling wave acquisition apparatuses in the adjacency group is 1, the reference traveling wave acquisition apparatus as a fault location reference terminal, and executing the single-terminal traveling wave fault location;
taking, in a case that the quantity of the traveling wave acquisition apparatuses in the adjacency group is 2, the reference traveling wave acquisition apparatus as a fault location reference terminal, and executing the double-terminal traveling wave fault location; or
executing, in a case that the quantity of the traveling wave acquisition apparatuses in the adjacency group is greater than 2, the double-terminal traveling wave fault location on each traveling wave acquisition apparatus in the adjacency group and other traveling wave acquisition apparatuses one by one, selecting a traveling wave acquisition apparatus having a greatest quantity of similar fault location results as a fault location reference terminal, and taking an average of all similar fault location results as the fault location result.

11. The distributed type traveling wave fault location method according to claim 10, **characterized in that**

a computation formula for the single-terminal traveling wave fault location in step 5 is as follows:

$$d_1 = \begin{cases} \dfrac{t_{m\_w2} - t_{m\_w1}}{2} v & L_{mm} \neq 0 \\ 0 & L_{mm} = 0 \end{cases},$$

where $d_1$ denotes a single-terminal traveling wave fault location result; m is a number of the reference traveling wave acquisition apparatus; $L_{mm}$ denotes a length from a mounting point of the reference traveling wave acquisition apparatus to a tail terminal of a line; $t_{m\_w1}$ denotes a traveling wave initial wave head time instant; $t_{m\_w2}$ is fault point reflected wave head time instant; and $v$ denotes a traveling wave velocity;
a computation formula for the double-terminal traveling wave fault location is as follows:

$$d_2 = \frac{1}{2}[L_{ij} + (t_{i\_w1} - t_{j\_w1})v],$$

where $d_2$ denotes a double-terminal traveling wave fault location result; $L_{ij}$ denotes a length of a line between a mounting point of traveling wave acquisition apparatus i and a mounting point of traveling wave acquisition apparatus j; $t_{i\_w1}$ denotes a traveling wave initial wave head time instant of traveling wave acquisition apparatus i; and $t_{j\_w1}$ denotes a traveling wave initial wave head time instant of traveling wave acquisition apparatus j; and a method for determining whether a fault location result is similar is as follows:

$$|\Delta d| < \Delta D_{set},$$

where $\Delta d$ denotes a difference between any two double-terminal traveling wave fault location results; and $\Delta D_{set}$ denotes a preset threshold, and in a case that the above formula is satisfied, it is determined that the fault location result is similar.

12. The distributed type traveling wave fault location method according to claim 1, **characterized in that** specific steps of step 6 are as follows:

separately determining, according to the fault location results of the upstream adjacency group and the downstream adjacency group, a fault position in the adjacency group; deeming, in a case that the fault location result is not less than preset threshold $D_{set}$ or a fault location reference terminal is not the reference traveling wave acquisition apparatus, that a fault is located in an adjacency group area; or deeming, in a case that the fault location result is less than preset threshold $D_{set}$ and a fault location reference terminal is the reference traveling wave acquisition apparatus, that a fault is located at an adjacency group area boundary or outside an adjacency group area;

selecting, in a case that one of the upstream adjacency group and the downstream adjacency group determines that a fault is located in an adjacency group area, and the other one determines that a fault is located at an adjacency group area boundary or outside an adjacency group area, a fault location result of an adjacency group that determines that a fault is located in an adjacency group area as the final fault location result;

selecting, in a case that the upstream adjacency group and the downstream adjacency group both determine that a fault is located at an adjacency group area boundary or outside an adjacency group area, an average of the fault location results of the upstream adjacency group and the downstream adjacency group as the final fault location result; and

deeming, in a case that the upstream adjacency group and the downstream adjacency group both determine that a fault is located in an adjacency group area, that current fault location is invalid.

13. A distributed type traveling wave fault location system, comprising a topology forming module, an information receiving and processing module, a topology correcting module, an area decomposing module, a fault location computing module, and a result determining module, **characterized in that**

the topology forming module, configured to number traveling wave acquisition apparatuses dispersedly mounted on a line, and form an adjacency information matrix according to mounting positions of the traveling wave acquisition apparatuses and a length parameter of the line;

the information receiving and processing module, configured to receive a fault traveling wave current waveform of each traveling wave acquisition apparatus, extract traveling wave head time instant according to the fault traveling wave current waveform, and select a traveling wave acquisition apparatus of which a traveling wave head first arrives as a reference traveling wave acquisition apparatus;

the topology correcting module, configured to correct the adjacency information matrix based on data of the traveling wave head time instant;

the area decomposing module, configured to acquire all adjacent traveling wave acquisition apparatuses of the reference traveling wave acquisition apparatus according to a corrected adjacency information matrix, and divide the adjacent wave acquisition apparatuses into an upstream adjacency group and a downstream adjacency group;

the fault location computing module, configured to carry out traveling wave fault location on the upstream adjacency group and the downstream adjacency group separately, and obtain two fault location results; and

the result determining module, configured to determine an adjacency group in which a fault is positioned according to the fault location results of the upstream adjacency group and the downstream adjacency group, and determine a final fault location result.

14. An electronic device, comprising:

a processor; and

a memory, wherein the memory stores a computer instruction, and when executed by the processor, the computer instruction causes the processor to carry out the method according to any one of claims 1 to 12.

15. A non-transitory computer storage medium, storing a computer program, wherein when executed by a plurality of processors, the computer program causes the processors to carry out the method according to any one of claims 1 to 12.

Number traveling wave acquisition apparatuses dispersedly mounted on a line, and form an adjacency information matrix according to mounting positions of the traveling wave acquisition apparatuses and a length parameter of the line ⟋ S100

Receive a fault traveling wave current waveform of each traveling wave acquisition apparatus, extract traveling wave head time according to the fault traveling wave current waveform, and select a traveling wave acquisition apparatus of which a traveling wave head first arrives as a reference traveling wave acquisition apparatus ⟋ S200

Correct the adjacency information matrix based on data of the traveling wave head time ⟋ S300

Acquire all adjacent traveling wave acquisition apparatuses of the reference traveling wave acquisition apparatus according to a corrected adjacency information matrix, and divide the adjacent traveling wave acquisition apparatuses into an upstream adjacency group and a downstream adjacency group ⟋ S400

Carry out traveling wave fault location on the upstream adjacency group and the downstream adjacency group separately, and obtain two fault location results ⟋ S500

Determine, according to the fault location results of the upstream adjacency group and the downstream adjacency group, an adjacency group in which a fault is located, and determine a final fault location result ⟋ S600

## FIG. 1

## FIG. 2

Assume that a reference traveling wave
acquisition apparatus has a number of
m, and another traveling wave
acquisition apparatus has a number of n,
and set an initial value n=1

$\eta_{mn}=0$ ? —— Yes

No

Is traveling
wave head time of traveling
wave acquisition apparatus
n valid? —— Yes

No

Correct all elements in
an mth row of an
adjacency information
matrix

Set $\eta_{mn}$ and $L_{mn}$ as 0

n=n+1

No —— n=N+1?

Yes

End

FIG. 3

1.2 km

2

1.4 km

3

1.5 km

7

8

2 km

2.6 km

1

K1

0.6 km

4

3 km

6

3.5 km

9

3.2 km

1.3 km

1.2 km

2.5 km

4.1 km

Traveling wave
head time is invalid

2.2 km

5

1.5 km

FIG. 4

FIG. 5

FIG. 6

FIG. 7

## INTERNATIONAL SEARCH REPORT

International application No.

**PCT/CN2024/079541**

### A. CLASSIFICATION OF SUBJECT MATTER

G01R31/08(2020.01)i

According to International Patent Classification (IPC) or to both national classification and IPC

### B. FIELDS SEARCHED

Minimum documentation searched (classification system followed by classification symbols)

IPC:G01R

Documentation searched other than minimum documentation to the extent that such documents are included in the fields searched

Electronic data base consulted during the international search (name of data base and, where practicable, search terms used)

CNTXT, ENTXTC, WPABSC, ENTXT, DWPI, CJFD, CNKI, IEEE: 行波, 分布式, 邻接, 相邻, 矩阵, 位置, 长度, 距离, 上游, 下游, 修正, 校准, 校正, distributed, traveling wave, position, length, distance, adjacent, adjoining, matrix, upstream, downstream, correction, amendment, revise, modify

### C. DOCUMENTS CONSIDERED TO BE RELEVANT

| Category* | Citation of document, with indication, where appropriate, of the relevant passages | Relevant to claim No. |
|---|---|---|
| A | 马金杰 等 (MA, Jinjie et al.). "直流配电线路多端行波故障定位算法 (Multi-terminal Traveling Wave Fault Location Algorithm for DC Distribution Lines)" 水电能源科学 *(Water Resources and Power)*, Vol. 38, No. 9, 25 September 2020 (2020-09-25), 188-192, 210 ISSN: 1000-7709, pages 188-192 and 210 | 1-15 |
| A | CN 102183708 A (SHANDONG KEHUI POWER AUTOMATION CO., LTD.) 14 September 2011 (2011-09-14) entire document | 1-15 |
| A | CN 107942193 A (STATE GRID HUNAN ELECTRIC POWER COMPANY et al.) 20 April 2018 (2018-04-20) entire document | 1-15 |
| A | CN 108020754 A (SHANDONG UNIVERSITY OF TECHNOLOGY) 11 May 2018 (2018-05-11) entire document | 1-15 |

☑ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 May 2024** | **01 June 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 592 692 A1**

<table>
<tr><td colspan="2"></td><td>INTERNATIONAL SEARCH REPORT</td><td>International application No.</td></tr>
<tr><td colspan="2"></td><td></td><td>**PCT/CN2024/079541**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| A | CN 110888014 A (NARI TECHNOLOGY CO., LTD. et al.) 17 March 2020 (2020-03-17)<br>  entire document | 1-15 |
| A | CN 115704844 A (STATE GRID SHANGHAI MUNICIPAL ELECTRIC POWER COMPANY et al.) 17 February 2023 (2023-02-17)<br>  entire document | 1-15 |
| A | US 2021156899 A1 (SHANDONG UNIVERSITY OF TECHNOLOGY) 27 May 2021 (2021-05-27)<br>  entire document | 1-15 |
| A | 张广斌 等 (ZHANG, Guangbin et al.). "基于回路电流故障主导波头到达时差的输电线路故障测距 (Traveling Wave Fault Location for Transmission Lines Based on Arrival Time Difference of Dominant Fault Induced Current Waves in Closed Loop Circuit)"<br>中国电机工程学报 (Proceedings of the CSEE),<br>Vol. 33, No. 28, 05 October 2013 (2013-10-05), 137-145<br>ISSN: 0258-8013,<br>  pages 137-145 | 1-15 |

Form PCT/ISA/210 (second sheet) (July 2022)

## INTERNATIONAL SEARCH REPORT
**Information on patent family members**

International application No.

**PCT/CN2024/079541**

| Patent document cited in search report | | | Publication date (day/month/year) | Patent family member(s) | | | Publication date (day/month/year) |
|---|---|---|---|---|---|---|---|
| CN | 102183708 | A | 14 September 2011 | CN | 102183708 | B | 08 May 2013 |
| CN | 107942193 | A | 20 April 2018 | None | | | |
| CN | 108020754 | A | 11 May 2018 | None | | | |
| CN | 110888014 | A | 17 March 2020 | WO | 2021072913 | A1 | 22 April 2021 |
| | | | | CN | 110888014 | B | 19 April 2022 |
| CN | 115704844 | A | 17 February 2023 | None | | | |
| US | 2021156899 | A1 | 27 May 2021 | US | 11408924 | B2 | 09 August 2022 |
| | | | | CN | 110927520 | A | 27 March 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310234087